(19)

Europäisches Patentamt

European Patent Office

Office européen des brevets

(11) **EP 4 361 726 A1**

(12) **EUROPEAN PATENT APPLICATION**

(43) Date of publication:
**01.05.2024 Bulletin 2024/18**

(21) Application number: **22203256.7**

(22) Date of filing: **24.10.2022**

(51) International Patent Classification (IPC):
**G03F 7/20** (2006.01)          **G06N 3/08** (2023.01)
**G06N 20/00** (2019.01)

(52) Cooperative Patent Classification (CPC):
**G03F 7/70616; G03F 7/705; G03F 7/70633;
G06N 3/08; G06N 20/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
 • **ONOSE, Alexandru
   5500 AH Veldhoven (NL)**

 • **MIDDLEBROOKS, Scott, Anderson
   5500 AH Veldhoven (NL)**
 • **VERHEUL, Nick
   5500 AH Veldhoven (NL)**
 • **VAN KRAAIJ, Markus, Gerardus, Martinus, Maria
   5500 AH Veldhoven (NL)**
 • **TIEMERSMA, Bart, Jacobus, Martinus
   5500 AH Veldhoven (NL)**
 • **CERFONTAINE, Pascal
   5500 AH Veldhoven (NL)**

(74) Representative: **ASML Netherlands B.V.
Corporate Intellectual Property
P.O. Box 324
5500 AH Veldhoven (NL)**

(54) **INFERENCE MODEL TRAINING**

(57)     A method of training an inference model to determine one or more parameters of a product of a fabrication process from measurements of the product. The method comprises obtaining a dataset (DS) of measurements of one or more products of the fabrication process, each of the measurements comprising an array of values obtained by measuring a corresponding one of the products. The method further comprises selecting a proper subset (SS) of the dataset for use in training the inference model, the subset being selected by applying an optimisation procedure to an objective function providing a measure of differences between each measurement in the dataset and corresponding reproduced values of the measurements obtained using a reproduction function having a domain comprising the measurements in the subset and excluding the measurements not in the subset. The method also comprises training the inference model using the proper subset of the dataset.

**FIG. 7**

**EP 4 361 726 A1**

**Description**

<u>TECHNICAL FIELD</u>

The present invention relates to methods and systems for training inference models that determine one or more parameters of a product of a fabrication process.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance.

To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads are also known, but provide only indirect evidence of the true product structure. By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

SUMMARY

According to an aspect of the invention, there is provided a method of training an inference model to determine one or more parameters of a product of a fabrication process from measurements of the product. The method comprises obtaining a dataset of measurements of one or more products of the fabrication process. Each of the measurements comprises an array of values obtained by measuring a corresponding one of the products. The method further comprises selecting a proper subset of the dataset for use in training the inference model. The subset is selected by applying an optimisation procedure to an objective function providing a measure of differences between each measurement in the dataset and corresponding reproduced values of the measurements obtained using a reproduction function having a domain comprising the measurements in the subset and excluding the measurements not in the subset. The inference model is trained using (only) the proper subset of the dataset of measurements; that is, the portion of the dataset of measurements which is not included in the proper subset, is not used in training the inference model.

This has the advantage that the training of the interference model is easier, since the number of measurements provided as input to the training model may be smaller than if the entire dataset were used. Experimentally, it has been found that interference results can be obtained which are almost as accurate as using the entire dataset of measurements in the training procedure, but with much reduced computational cost.

The reproduction function may generate the reproduced values of a measurement as a weighted sum of combinations of the arrays of the measurements in the subset. The combinations of the arrays may be linear or non-linear combinations, e.g. a weighted sum of the arrays of the measurements in the subset or a weighted sum of products of corresponding values of two or more of the arrays of the measurements in the subset. The reproduced values of a measurement in the dataset may be an approximation to the values of the array of the measurement in the dataset obtained by projecting the array of the measurement onto a space spanned by the measurements in the subset. The measure of differences between each measurement in the dataset and corresponding reproduced values of the measurements may be, for example, comprise residuals between the values of the array of a measurement and the corresponding reproduced values of the array of that measurement, e.g. a sum of squares of residuals. For example, the measure used may be a Frobenius norm. The arrays may be one dimensional (e.g. a vector) or two dimensional (e.g. a 2D matrix) or higher dimensional (e.g. a 3D, 4D etc. matrix). The dimensionality of the arrays is generally the same or less than the dimensionality of the measurements in the dataset.

In another aspect of the invention, once the proper subset of the measurements has been selected, when further operation of the fabrication process is carried out to make further products, measurements of the further products may omit measuring at least one measurement included in the dataset of measurements but omitted from the proper subset of measurements. In this way, the effort required to perform the measurements is reduced, while still capturing sufficient information to characterize the fabrication process. For example, the measurement of the further products of the fabrication process may include only measurements corresponding to measurements of the selected subset. The measurements of further products of the fabrication process may be used in the inference model trained on the selected measurements of the products of the earlier fabrication process, or may be used in training a new inference model. Reducing the number of measurements which are made speeds up the measurement process, and increases the throughput of the fabrication process. Again, experimental results indicate that this is possible without significant reduction of the quality of the inspection process.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 depicts a schematic overview of a lithographic apparatus, according to an embodiment.

Figure 2 depicts a schematic overview of a lithographic cell, according to an embodiment.

Figure 3 depicts a schematic representation of holistic lithography, representing a cooperation between three technologies to optimize semiconductor manufacturing, according to an embodiment.

Figure 4 illustrates an example metrology apparatus, such as a scatterometer, according to an embodiment.

Figure 5 is a flow chart of a method of training an inference model according to an embodiment.

Figure 6 is a schematic representation of a top view of a wafer showing sites on the wafer from which measurements are obtained and a division of the wafer into quadrants.

Figure 7 depicts a method of sampling measurements from a dataset according to an embodiment.

Figure 8 depicts a method of sampling measurements from a dataset according to an embodiment.

Figure 9 depicts a method of sampling measurements from a dataset according to an embodiment.

Figure 10A is a schematic representation of a top view of a wafer showing inferred tilt values obtained from a tilt inference model trained using pupil image measurements at each of a plurality of sites on the wafer.

Figure 10B is a graph showing the tilt values of Figure 10A as a function of radial distance from the centre of the wafer.

Figure 10C is a schematic representation of the top view of the wafer of Figure 10A showing measured tilt values for a subset of the sites selected for use in training a further tilt inference model.

Figure 10D is a graph showing the tilt values of Figure 10C as a function of radial distance from the centre of the wafer.

Figure 10E is a schematic representation of the top view of the wafer of Figures 10A and 10B showing inferred tilt values for all the sites on the wafer determined from the pupil image measurements using the trained further tilt inference model.

Figure 10F is a graph showing the tilt values of Figures 10E as a function of radial distance from the centre of the wafer.

Figure 11 is a block diagram of an example computer system, according to an embodiment.

## DETAILED DESCRIPTION

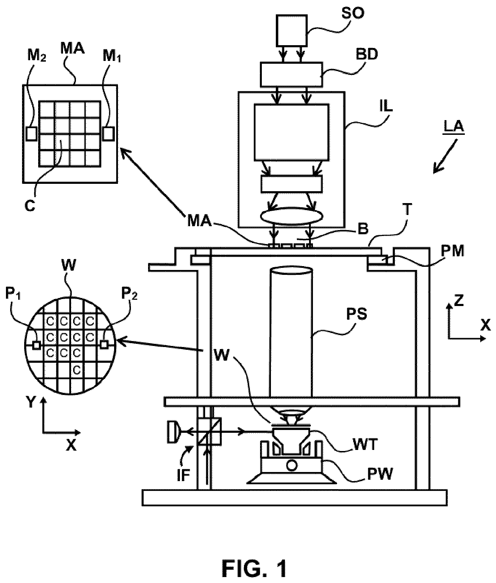

As a brief introduction, Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT configured to hold a substrate (e.g., a resist coated wafer) W and coupled to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

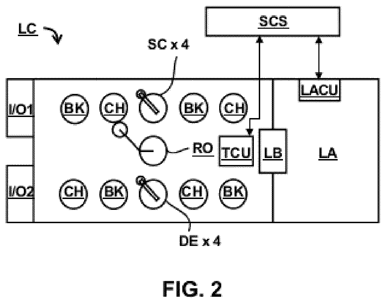

Figure 2 depicts a schematic overview of a lithographic cell LC. As shown in Figure 2 the lithographic apparatus LA may form part of lithographic cell LC, also sometimes referred to as a lithocell or (litho)cluster, which often also includes apparatus to perform pre- and post-exposure processes on a substrate W. Conventionally, these include spin coaters SC configured to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W (Figure 1) exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W (Figure 1), and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

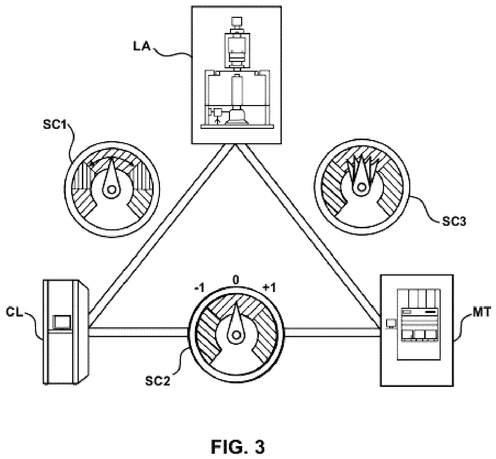

Figure 3 depicts a schematic representation of holistic lithography, representing a cooperation between three technologies to optimize semiconductor manufacturing. Typically, the patterning process in a lithographic apparatus LA is one of the most critical steps in the processing which requires high accuracy of dimensioning and placement of structures on the substrate W (Figure 1). To ensure this high accuracy, three systems (in this example) may be combined in a so called "holistic" control environment as schematically depicted in Figure. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure features of a substrate such as gratings using light from soft x-ray and visible to near-IR wavelength range, for example.

In some embodiments, a scatterometer MT is an angular resolved scatterometer. In these embodiments, scatterometer reconstruction methods may be applied to the measured signal to reconstruct or calculate properties of a grating and/or other features in a substrate. Such reconstruction may, for example, result from simulating interaction of scattered radiation with a mathematical model of the targetstructure and comparing the simulation results with those of a measurement. Parameters of the mathematical model are adjusted until the simulated interaction produces a diffraction pattern similar to that observed from the real target.

In some embodiments, scatterometer MT is a spectroscopic scatterometer MT. In these embodiments, spectroscopic scatterometer MT may be configured such that the radiation emitted by a radiation source is directed onto target features of a substrate and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In some embodiments, scatterometer MT is a ellipsometric scatterometer. The ellipsometric scatterometer allows for determining parameters of a lithographic process by measuring scattered radiation for each polarization states. Such a metrology apparatus (MT) emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety. [00214] In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in patent application EP1,628,164A, such that any asymmetry is clearly distinguishable. This provides a way to measure misalignment in gratings. Further examples for measuring overlay may be found in PCT patent application publication no. WO 2011/012624 or US patent application US 20160161863, incorporated herein by reference in their entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure (e.g., feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings and/or other features in a substrate, formed by a lithographic process, commonly in resist, but also after etch processes, for example. In some embodiments, one or more groups of targets may be clustered in different locations around a wafer. Typically the pitch and line-width of the structures in the gratings depend on the measurement optics (in particular the NA of the optics) to be able to capture diffraction orders coming from the metrology targets. A diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US2016/0370717A1 incorporated herein by reference in its entirety.

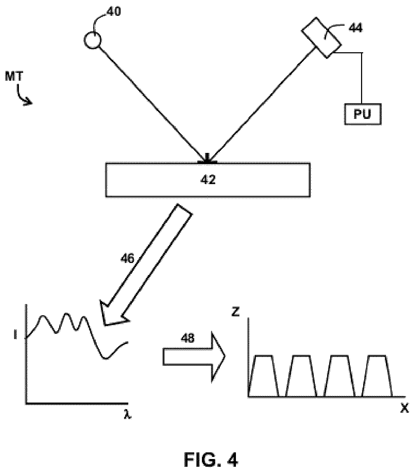

Figure 4 illustrates an example metrology apparatus (tool or platform) MT, such as a scatterometer. MT comprises a broadband (white light) radiation projector 40 which projects radiation onto a substrate 42. The reflected or scattered radiation is passed to a spectrometer detector 44, which measures a spectrum 46 (i.e. a measurement of intensity as a function of wavelength) of the specular reflected radiation. From this data, the structure or profile giving rise to the detected spectrum may be reconstructed 48 by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer, for example.

It is often desirable to be able to computationally determine how a patterning process would produce a desired pattern on a substrate. Computational determination may comprise simulation and/or modeling, for example. Models and/or simulations may be provided for one or more parts of the manufacturing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), manufacturing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Simulation and/or modeling can be used to determine one or more metrology metrics (e.g., performing overlay and/or other metrology measurements), configure one or more features of the patterning device pattern (e.g., performing optical proximity correction), configure one or more features of the illumination (e.g., changing one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, inspection operation variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection and/or an inspection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

An inference model may be used to determine one or more properties of a product of a fabrication process from measurements of the product. Examples of such inference models are described below with reference to wafers that are obtained from lithographic processes, but it will be appreciated that other inference models can be used for products other than wafers or products of fabrication processes other than lithographic processes. The one or more parameters determined by the inference model may characterise the height or depth of a feature, the width of the feature of a structure (e.g. a periodic structure) on the wafer, for example.

Training of an inference model is influenced by the locations of the metrology targets on the product. For example, if the metrology targets used to train the inference model are concentrated in regions of the product for which there is little variation in properties then the trained inference model may be poor at determining parameters characterising variations in those properties in other parts of the product. In other words, the inference model may be biased such that it is not able to accurately capture variations in properties of products that may occur in some regions of the product that are sparsely represented in the dataset. Increasing the number of measurements/metrology targets does not necessarily improve the accuracy of the inference model in such cases and may make training the model intractable.

Wafers are typically provided with large numbers of metrology targets and a dataset comprising measurements from each of the targets is typically used when training an inference model, although there may be some filtering applied to the dataset to remove measurements that have failed and/or are outliers. The large size of the dataset means that considerable computational resources are required to train the inference model. The inference model may, in general, be an artificial neural network, e.g. a deep neural network and/or a convolutional neural network, which takes measurements of the product as inputs and provides one or more parameters of the product as output(s). The artificial neural network may, for example, comprise an autoencoder. The autoencoders may be configured to compress the dataset of measurements (e.g. pupil images) to an efficient low dimensional representation of the same dataset that then can be used for parameter inference (i.e. regression).

As mentioned above, metrology targets may comprise diffraction gratings comprising parallel lines formed on the surface of the wafer, the lines having sidewalls that extend in a depth direction perpendicular to the surface of the wafer. Variations in the fabrication process may cause the sidewalls of the lines to be tilted by a small amount with respect to the depth direction, i.e. the sidewalls deviate from being perpendicular to the surface of the wafer. Such deviations may be referred to as "tilt" or "pattern tilt" and typically have a magnitude and direction that varies over the surface of the wafer. Tilt may be measured from an image of the metrology target obtained in the pupil plane of a scatterometer. Measurements of tilt obtained this way may then be used to train an inference model to determine tilt for a wafer from pupil plane images of metrology targets provided on the wafer. A dataset of measurements suitable for training the inference model may, for example, be obtained by producing wafers under different etching conditions so that the tilt of the wafers has significant variation across the dataset. Tilt inference models may be difficult to train accurately for some datasets because the largest magnitude tilts are found near the edges of the wafer, such that using additional measurements from metrology targets away from the edges of the wafer does little to improve accuracy of the inference model in the regions where tilt is more pronounced and may instead decrease the ability of the model to accurately determine tilts at the edges of the wafer.

Another parameter of interest for wafers (or more generally, products obtained by lithographic processes) relates to a displacement (or "overlay") of one structure on the wafer in a direction transverse to the surface of the wafer relative to another structure spaced apart from the structure along a depth direction perpendicular to the surface. Measurements indicative of such displacements of pairs of structures may be referred to as overlay measurements. The measurements may be used to train an inference model to determine one or more parameters characterising overlay for a wafer from other such measurements.

As described herein, rather than use measurements from all of the metrology targets to train an inference model, the inference model may instead be trained using a subset of the dataset, i.e. a "proper" subset of the dataset containing some but not all of (and typically very many fewer than) the measurements in the dataset. The subset is preferably selected to capture the distribution of measurements within the dataset efficiently. For example, the measurements in the subset may be obtained based on their importance of representing the overall information contained in the dataset, with measurements that are relatively uninformative of the distribution being omitted from the subset.

The dataset of measurements may be represented mathematically by a matrix (or more generally, a tensor), $D_N$, where $N$ is the number of measurements in the dataset and the matrix has $N$ columns, with each of the columns having values that collectively define one of the measurements, i.e. each measurement is represented by a column vector of values. The problem of selecting a subset of measurements, $S_M$ (where $M$ is the number of measurements in the subset; $M$ is an integer less than the integer $N$) that is most representative of the dataset of $N$ measurements may then be defined by the following optimization problem:

$$S_M = \mathrm{argmin}_{S_M} \left\| D_N - P_{S_M}(D_N) \right\| \tag{1}$$

where "argmin" is the argument (i.e. the subset) corresponding to the minimum of the matrix norm in the equation, $P_{S_M}(D_N)$ is a projection operator that projects each of the measurements in the dataset onto measurements of the subset, and $\|\cdot\|$ denotes a norm operation. In a simple example, the projection operator $P_{S_M}(D_N)$ may be a linear operator. The optimal subset in this case is the subset for which each column vector of measurements in the dataset can be most accurately represented by linear combinations of the column vectors of the measurements in the subset, i.e. wherein $D_N \approx D_M \times W$, where $D_M$ is a matrix of the column vectors of each of the measurements in the subset and $W$ is a matrix of column vectors that each defines a linear combination of the column vectors in $D_M$ that best fits a corresponding one of the column vectors in $D_N$. The matrix norm used to provide a measure of the difference ("projection error") between each of the column vectors in the dataset and its projection onto the column vectors in the subset may in this case be the Frobenius norm, i.e. the sum of the squares of the difference of each element in the matrix from $D_N$ from the corresponding element in its projection. However, other matrix norms may be used in some cases. It is also possible to define a generalised version of the above equation in which the measurements in the dataset are projected onto the measurements in the subset using a non-linear mapping, rather than a linear projection operator.

Solving equation (1) to find the optimum subset of measurements is generally challenging because of the large numbers of measurements in most datasets. Nevertheless, a variety of selection algorithms exist for obtaining the optimum (or a nearly optimum) subset. One such selection algorithm is termed "Kernel Spectrum Pursuit" which iteratively selects $M$ column vectors (measurements) whose span is close to that of the first $M$ spectral components of the dataset. This algorithm is described in M. Joneidi et al., "Select to Better Learn: Fast and Accurate Deep Learning Using Data Selection From Nonlinear Manifolds," 2020 IEEE/CVF Conference on Computer Vision and Pattern Recognition (CVPR), 2020, pp. 7816-7826, doi: 10.1109/CVPR42600.2020.00784, the contents of which are incorporated herein by reference.

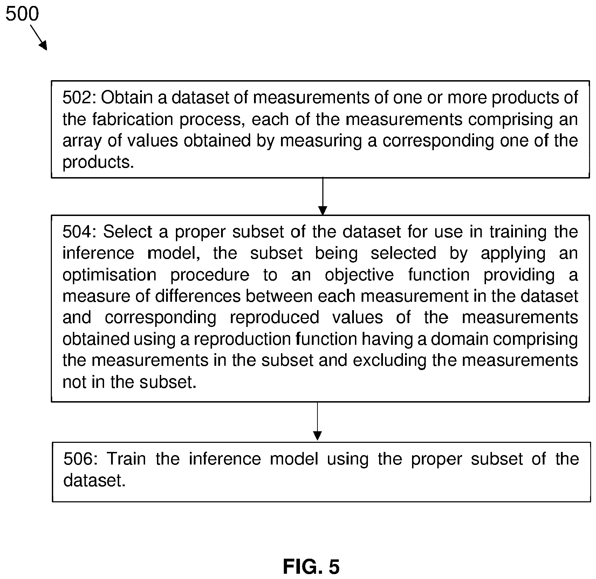

Figure 5 is a flowchart showing the steps of a method 500 of training an inference model to determine one or more parameters of a product of a fabrication process (e.g. a lithographic process) from measurements of the product. As an example, the product may be a wafer produced by a lithographic process and the inference model may be trained to determine one or more parameters of the wafer, such as parameters characterising tilt, from images of metrology targets on the wafer obtained in a pupil plane of a scatterometer.

A first step 502 of the method 500 comprises obtaining a dataset of measurements of one or more products of the fabrication process, each of the measurements comprising an array of values obtained by measuring a corresponding one of the products.

A second step 504 of the method 500 (which may be referred to as "subset selection") comprises selecting a proper subset of the dataset for use in training the inference model, the subset being selected by applying an optimisation procedure to an objective function providing a measure of differences between each measurement in the dataset and corresponding reproduced values of the measurements obtained using a reproduction function having a domain comprising the measurements in the subset and excluding the measurements not in the subset. For example, Kernel Spectrum Pursuit may be applied to the objective function defined by Equation (1) above to select the measurements in the subset.

A third step 506 of the method 500 may comprise training the inference model using the measurements in the subset, preferably in combination with known values of the one or more parameters of each of the one or more products, i.e. by supervised learning.

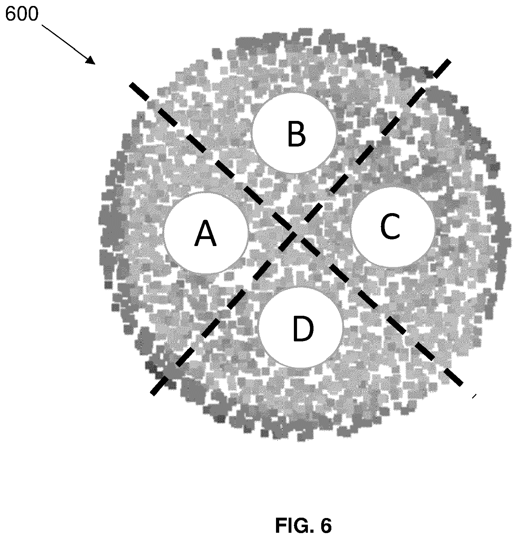

Figure 6 shows a top view of an exemplary wafer 600 with markings identifying locations of metrology targets on the surface of the wafer from which measurements are obtained. Each measurement may, for example, be an image of the metrology target obtained in a pupil plane of a scatterometer. The measurement may, for example, be indicative of a tilt at the location of the metrology target. The surface of the wafer 500 is subdivided into four equal quadrants A-D so that each of metrology targets belongs to one of the quadrants. Note that in an alternative embodiment, the surface of the wafer may be subdivided into regions which are circular and/or annular sectors defined with respect to an axis normal to a face or layer of the wafer.

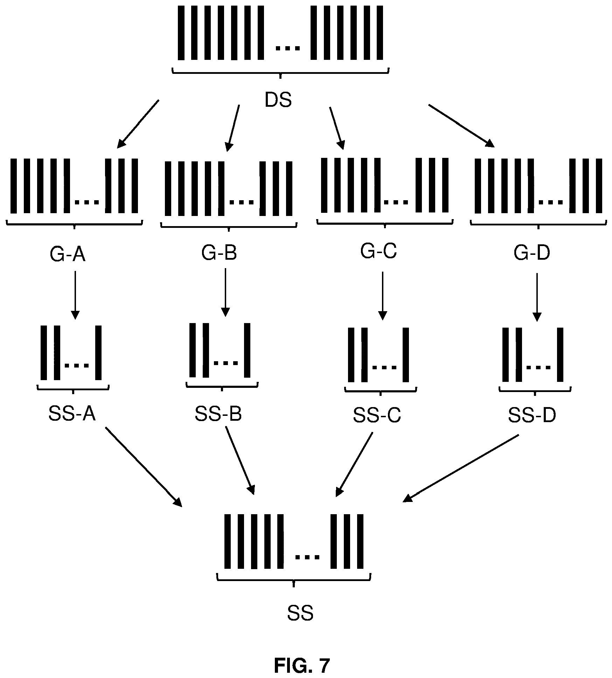

Figure 7 is an illustrative view of how the measurements of the wafer 600 may be selected for use in training an inference model according to an embodiment of the invention.

The measurements of the wafer collectively form a dataset DS. The measurements are then grouped into four non-overlapping groups, G-A, G-B, G-C and G-D. For each of the groups, a subset of the measurements in the group is then selected. Each subset SS-A, SS-B, SS-C and SS-D is selected by solving Equation (1) as described above (with the dataset being replaced by the measurements belonging to the group). The subsets SS-A, SS-B, SS-C and SS-D of each of the groups are then combined, e.g. by taking the union of the subsets, to obtain the subset SS of the dataset as a whole for use in training the inference model.

Grouping the measurements and then applying subset selection to the measurements in each of the groups may, for example, ensure that measurements selected for use in training the inference model are representative of each of the groups. Such an approach may ensure that measurements characteristic of each of the groups are not omitted from the subset used to train the inference model. For example, the lithographic process used to produce the wafer 500 may be known or expected to produce variations in tilt that have a characteristic distribution across the wafer. In this case of the wafer 600 of Figure 6, the variations may lead to different distributions of tilts in each of the four quadrants.

By grouping the measurements according to quadrant, measurements representative of the distribution of tilts within each quadrant can be selected, thereby ensuring that the inference model is trained appropriately for measurements from each of the quadrants.

More generally, the measurements may be grouped according to metadata associated with the measurements. For example, the metrology targets may be arranged in clusters on the surface of the wafer (e.g. the clusters may be measurement data relating to the respective quadrants A, B, C and D shown in Fig. 6, or relating to regions which are circular and/or annular sectors defined with respect to an axis normal to a face or layer of the wafer) and the measurements may be grouped according to metadata indicative of from which cluster the measurements were obtained. Such an approach may allow the optimum metrology targets in each cluster to be selected for training the inference model, for example.

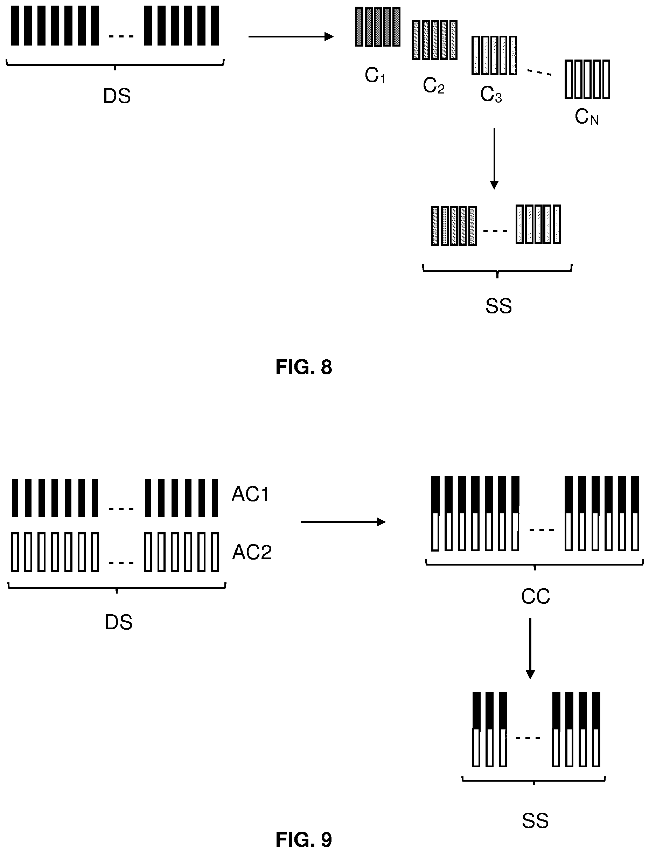

Figure 8 is an illustrative view of how measurements of a wafer may be selected for use in training an inference model according to an embodiment of the invention, in which the subset selection approach may be used to identify which of the clusters are important for representing the dataset (e.g. which clusters are responsible for most of the variation in the dataset). The measurements in the dataset DS may be grouped according to from which cluster the measurements were obtained, to obtain a plurality of subsets, one for each cluster, $C_1$-$C_N$. The measurements within each of the cluster subsets $C_1$-$C_N$ may then be concatenated, so that the dataset may then be represented by a matrix having respective columns formed by the concatenated measurements of the each of the cluster subsets $C_1$-$C_N$. That is, each of the columns is the concatenated measurements for one of the cluster-subsets. The subset selection approach may then be applied to the select a subset SS of the columns that best represents the dataset DS. Such an approach may allow optimum clusters of the metrology targets (or combinations thereof) to be selected for training the inference model, for example. Further subset selection may be applied to the measurements in each of the selected clusters by applying subset selection to the group for each selected cluster individually and/or applying subset selection across the groups of the selected clusters.

Figure 9 is an illustrative view of how measurements of a wafer may be selected for use in training an inference model according to an embodiment of the invention, in which the measurement process used to obtain the measurements in the dataset DS may have a number of acquisition channels AC1, AC2. The acquisition channels may include, for example, different wavelengths and/or different polarisations of electromagnetic radiation may be used by a scatterometer to obtain the measurements. Measurements for different acquisition channels may of course be grouped, e.g. according to whether the measurements were obtained from the same region or metrology target. In some examples, measurements for different acquisition sites may be concatenated to produce a set of concatenated measurements CC to which subset selection may be applied. The subset selection approach may then be applied to the select a subset SS of the columns that best represents the dataset DS.

In a further example, measurements made using different acquisition channels may be grouped by channel and the subset selection approach applied to identify which measurements in each channel are most representative. This would mean that for some locations on the product, all channels are included in the proper subset of measurements; for other locations, only a proper subset of the channels are included in the proper subset of measurements; and for other locations, none of the channels is included in the proper subset of measurements. Alternatively or additionally, measurements in each channel may be concatenated and subset selection applied to the concatenated measurements of the channels collectively in order to identify which of the channels are most representative of the variation in the dataset as a whole. Such an approach may allow optimum channels of the measurement process (or combinations thereof) to be selected for training the inference model, for example.

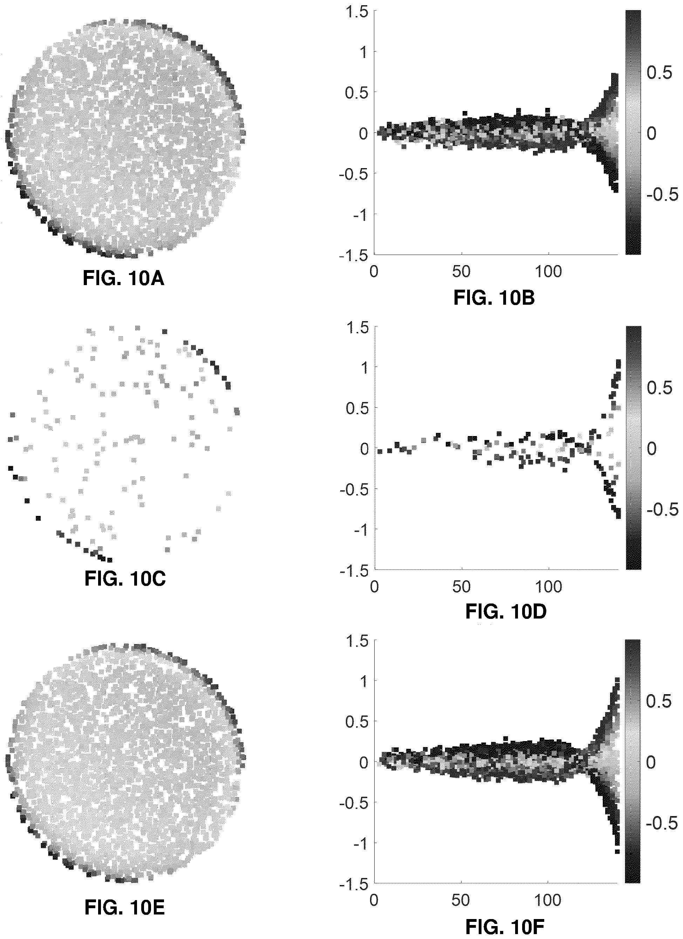

Figure 10A shows a representation of tilt values obtained from measurements at each of a plurality of regions of a wafer. The tilt values were determined by training a tilt inference model on measurements made for a plurality of wafers, with measurements of some of the wafers being used for training and the measurements for the rest of the wafers being used for validation. The measurements were pupil plane images obtained using a scatterometer, with two acquisition channels.

Figure 10B shows a graph having a horizontal axis denoting radial distance (in arbitrary units) from the centre of the wafer and the vertical axis denoting the inferred tilt values (also in arbitrary units) obtained using the trained tilt inference model. The negative tilt values are predominantly obtained from the lower left-hand quadrant of the wafer shown in Figure 10A, whilst the positive tilt values are predominantly obtained from the upper right-hand quadrant.

Figures 10C and 10D are analogous to Figures 10A and 10B, except that only the tilt values for a subset of the measurements for the wafer are indicated. This subset is obtained by selecting the 60 most important (i.e. most representative) measurements per channel for each of the wafers used to train the inference model. The selected measurements are then combined (by taking their union) to form the subset. The subset has approximately 5% of the number of measurements of the original dataset.

Figures 10E and 10F are analogous to Figures 10A and 10B, except that the tilt values are obtained using the tilt inference model trained using only the measurements of the subset. It should be noted that because, in these examples, each of the inference models outputs the tilt values in (different) arbitrary units, the magnitudes of the tilt values determined by the two tilt inference models are not directly comparable. However, it can be seen that the respective shapes of the envelopes of the tilt values in Figures 10B and 10F correspond very closely with one another and it is observed that there is very good agreement between the tilt values determined by the inference model trained with the full dataset and the corresponding tilt values determined by the inference model trained with only the subset.

Once an optimum (or nearly optimum) subset of measurements has been determined, the information gained from selecting the subset of measurements may be used to ensure that only these particular measurements (or ones closely analogous to them) are made when subsequent inference models are to be trained. In particular, the optimum subset of measurements may be provided for a particular parameter, or type of parameter, characterising the wafer when a new inference model for the parameter (or type of parameter) needs training. Information characterising such optimum subsets of measurements may, for example, be provided in the form of a list of metrology targets from which measurements should be made, the lists identifying only a subset of the metrology targets provided on the wafer. Optionally, the lists may differ according to which parameter the inference model determines, e.g. there may be a different list for training a tilt inference model compared with training an overlay inference model. In some implementations, the subset selection approach may be used to reduce the number of metrology targets provided on the wafer, e.g. by including on the subsequent wafers only the metrology targets that were selected for the subset.

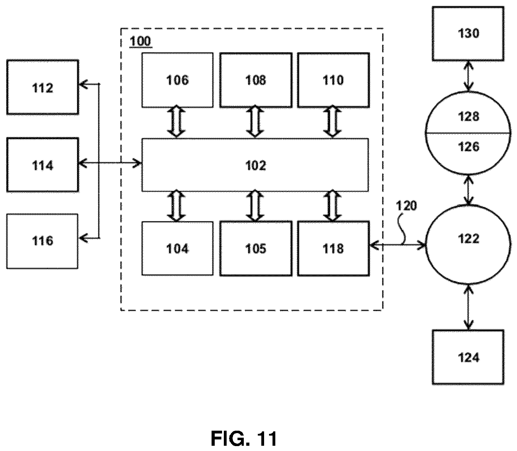

Figure 11 is a block diagram that illustrates a computer system 100 that can perform and/or assist in implementing the methods, flows, systems, or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" or "machine-readable" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

Further embodiments are disclosed in the following list of numbered clauses:

1. A method of training an inference model to determine one or more parameters of a product of a fabrication process from measurements of the product, the method comprising:

obtaining a dataset of measurements of one or more products of the fabrication process, each of the measurements comprising an array of values obtained by measuring a corresponding one of the products;
selecting a proper subset of the dataset for use in training the inference model, the subset being selected by applying an optimisation procedure to an objective function providing a measure of differences between each measurement in the dataset and corresponding reproduced values of the measurements obtained using a reproduction function having a domain comprising the measurements in the subset and excluding the measurements not in the subset; and
training the inference model using the proper subset of the dataset.

2. A method according to clause 1, wherein selecting the proper subset of the dataset for use in training the inference model comprises:

assigning each of the measurements of the dataset to one or more of a plurality of groups according to metadata associated with one or more of: the measurement; the product corresponding to the measurement; and the fabrication process used to produce the product corresponding to the measurement; and
applying the optimisation procedure to select measurements from each of the groups separately such that the subset comprises measurements from each of the groups.

3. A method according to clause 2, wherein applying the optimisation procedure to select measurements from each of the groups separately comprises:

for each of the one or more groups, selecting a subset of the measurements assigned to the group by applying the optimisation procedure to optimise the objective function for the measurements assigned to the group over a sub-domain of the reproduction function comprising the measurements assigned to the group and excluding the measurements not assigned to the group; and
combining measurements from two or more respective subsets of the groups to select the subset of the dataset for use in training the inference model.

4. A method according to clause 3, wherein the training data is obtained from the union or intersection of the two or more respective subsets of the groups.

5. A method according to clause 1, wherein selecting the proper subset of the dataset for use in training the inference model comprises:

assigning each of the measurements of the dataset to one or more of a plurality of groups according to metadata associated with one or more of: the measurement; the product corresponding to the measurement; and the fabrication process used to produce the product corresponding to the measurement; and

applying the optimisation procedure to select one or more of the groups of measurements such that the subset comprises measurements from each of one or more selected groups and does not comprise measurements from each of one or more unselected groups.

6. A method according to clause 5, wherein applying the optimisation procedure to select one or more of the groups of measurements comprises:

for each of the groups, combining the measurements assigned to the group to obtain a corresponding concatenated array of measurements for that group; and

selecting a subset of the concatenated arrays by applying the optimisation procedure to optimise the objective function, the objective function providing a measure of differences between the values of each concatenated array and corresponding values of a reproduction of the concatenated array obtained using the reproduction function, the domain of the reproduction function comprising the concatenated arrays of the measurements in the subset and excluding the concatenated arrays of measurements not in the subset; and

combining measurements from the concatenated arrays in the subset to select the subset of the dataset for use in training the inference model.

7. A method according to any one of clauses 2 to 6, wherein the metadata is indicative of from which of a plurality of regions of the product the measurement was obtained.

8. A method according to clause 7, wherein the regions are angular sectors, such as quadrants, defined with respect to an axis normal to a face or layer of the product.

9. A method according to clause 7, wherein the regions are circular and/or annular sectors defined with respect to an axis normal to a face or layer of the product.

10. A method according to any one of clauses 2 to 9, wherein the metadata is indicative of from which of a plurality of metrology targets formed on or within the product the measurement was obtained.

11. A method according to any one of clauses 2 to 10, wherein the metadata is indicative of from which product the measurement was obtained.

12. A method according to any one of clauses 2 to 11, wherein the metadata is indicative of which of a plurality of acquisition channels of a measurement process was used to obtain the measurement.

13. A method according to clause 12, wherein the each of the acquisition channels correspond to a respective one or more wavelengths and/or polarisations of electromagnetic radiation used in the measurement process and/or a respective rotation of the product around an axis associated with the measurement process, such as an imaging direction.

14. A method according to any one of the preceding clauses in which the fabrication process is a lithographic process.

15. A method according to clause 14, wherein the metadata is indicative of etch conditions used in the lithographic process.

16. A method according to any one of the preceding clauses in which the fabrication process is a wafer fabrication process and each of the one or more products is a fabricated wafer.

17. A method according to any one of the preceding clauses in which each of the products includes a plurality of layers spaced apart in a depth direction, and the one or more parameters of a product determined by the inference model include one or more numerical parameters which respectively indicate one of:

a translational offset transverse to the depth direction of two structures in the product in different respective said layers;

an angle made between one or more walls of a structure and the depth direction;

an angular offset transverse to the depth direction of the respective length directions of two elongate structures in the product in different respective layers; or

a spacing in the depth direction between two structures in the product.

18. A method according to any one of the preceding clauses, wherein the measurements each comprise one or more pupil images of the corresponding product captured in a pupil plane of a scatterometer.

19. A method according to any one of the preceding clauses, wherein the number of measurements in the subset is less than 50% of the number of measurements in the dataset, preferably less than 20%, and more preferably less than 10%.

20. A method according to any one of the preceding clauses, in which the training of the inference model uses the subset of the dataset in combination with known values of the one or more parameters of each of the one or more products.

21. A method according to any one of the preceding clauses, further comprising using the trained inference model to determine one or more parameters of a product of the fabrication process from measurements of the product.

22. A method according to clause 21, further comprising adjusting the fabrication process in response to the one or more parameters determined by the trained inference model.

23. A method according to any one of the preceding clauses, wherein the inference model comprises an artificial neural network, preferably an autoencoder.

24. A method according to any one of the preceding clauses, wherein the dataset is a first dataset, the method further comprising training a second inference model to determine one or more parameters of a product of a fabrication process from measurements of the product of the fabrication process, wherein training the second inference model comprises:

obtaining a second dataset of measurements of one or more products of the fabrication process, each of the measurements in the second dataset corresponding to a respective one of the measurements in the subset selected from the first dataset; and

training the second inference model using the measurements in the second dataset.

25. A method according to clause 24, wherein the second inference model is trained using the measurements in the second dataset in combination with known values of the one or more parameters of each of the one or more products of the second fabrication process.

26. A method according to clause 24, wherein the second inference model is trained using the measurements in the second dataset in combination with values of the one or more parameters of each of the one or more products determined from the measurements in the second dataset using the first inference model.

27. A method according to any one of clauses 24 to 26, wherein each of the measurements of the second dataset, and the measurements of the first dataset corresponding to the measurements of the second dataset, were obtained from one or more of: corresponding regions of the product; corresponding metrology targets on or within the product; and/or corresponding acquisitions channel of a measurement process.

28. A method of determining one or more parameters of a product of a fabrication process from measurements of the product, the method comprising:

obtaining a dataset of measurements of one or more products of the fabrication process, each of the measurements comprising an array of values obtained by measuring a corresponding one of the products, wherein each of the measurements in the dataset corresponds to a respective one of a plurality of measurements selected from another dataset of measurements of one or more products of the fabrication process, each of the measurements comprising an array of values obtained by measuring a corresponding one of the products of the fabrication process, the subset being selected by applying an optimisation procedure to an objective function providing a measure of differences between each measurement in the other dataset and corresponding reproduced values of the measurements obtained using a reproduction function having a domain comprising the measurements in the subset and excluding the measurements not in the subset; and

using an inference model trained using the measurements of the dataset and/or the measurements of the proper subset of the other dataset to determine the one or more parameters of each of the one or more products.

29. A method according to clause 28, wherein the inference model is trained using the measurements in the dataset in combination with known values of the one or more parameters of each of the one or more products of the fabrication process.

30. A method according to clause 28, wherein the inference model is trained using the measurements in the dataset in combination with values of the one or more parameters of each of the one or more products determined from the measurements in the dataset using an inference model trained using the measurements in the subset.

31. A method according to any one of clauses 28 to 30, wherein each of the measurements and the other measurement corresponding to the measurement were obtained from one or more of: corresponding regions of the product; corresponding metrology targets on or within the product; and/or corresponding acquisitions channel of a measurement process.

32. A method according to clause 27 or 31, wherein the measurement process comprises an imaging process having an imaging direction and the acquisition of the measurement process are each indicative of:

an orientation of the one or more products with respect to the imaging direction;
a spacing between repeated elements of a periodic structure, such as a diffraction grating, formed on or within the one or more products;
a translational position of the one or more products transverse to the imaging direction; or
a wavelength and/or polarization of electromagnetic radiation employed in the imaging process.

33. A computing system comprising a processor and a memory, the memory storing program instructions operative, upon being performed by the processor to cause the processor to perform a method according to any one of clauses 1 to 24.

34. A metrology system for determining one or more parameters of a product of a fabrication process from metrology signals characterising the product, the metrology system comprising a computing system according to clause 33 and a metrology apparatus configured to perform measurements on the product to obtain the metrology signals.

35. A computer program product storing program instructions operative, upon being performed by the processor to cause the processor to perform a method according to any of clauses 1 to 24.

**Claims**

1. A method of training an inference model to determine one or more parameters of a product of a fabrication process from measurements of the product, the method comprising:

obtaining a dataset of measurements of one or more products of the fabrication process, each of the measurements comprising an array of values obtained by measuring a corresponding one of the products;
selecting a proper subset of the dataset for use in training the inference model, the subset being selected by applying an optimisation procedure to an objective function providing a measure of differences between each measurement in the dataset and corresponding reproduced values of the measurements obtained using a reproduction function having a domain comprising the measurements in the subset and excluding the measurements not in the subset; and
training the inference model using the proper subset of the dataset.

2. A method according to claim 1, wherein selecting the proper subset of the dataset for use in training the inference model comprises:

assigning each of the measurements of the dataset to one or more of a plurality of groups according to metadata associated with one or more of: the measurement; the product corresponding to the measurement; and the fabrication process used to produce the product corresponding to the measurement; and
applying the optimisation procedure to select measurements from each of the groups separately such that the subset comprises measurements from each of the groups.

3. A method according to claim 2, wherein applying the optimisation procedure to select measurements from each of the groups separately comprises:

for each of the one or more groups, selecting a subset of the measurements assigned to the group by applying the optimisation procedure to optimise the objective function for the measurements assigned to the group over a sub-domain of the reproduction function comprising the measurements assigned to the group and excluding the measurements not assigned to the group; and
combining measurements from two or more respective subsets of the groups to select the subset of the dataset for use in training the inference model.

4. A method according to claim 3, wherein the training data is obtained from the union or intersection of the two or more respective subsets of the groups.

5. A method according to claim 1, wherein selecting the proper subset of the dataset for use in training the inference model comprises:

assigning each of the measurements of the dataset to one or more of a plurality of groups according to metadata associated with one or more of: the measurement; the product corresponding to the measurement; and the fabrication process used to produce the product corresponding to the measurement; and
applying the optimisation procedure to select one or more of the groups of measurements such that the subset comprises measurements from each of one or more selected groups and does not comprise measurements from each of one or more unselected groups.

6. A method according to claim 5, wherein applying the optimisation procedure to select one or more of the groups of measurements comprises:

for each of the groups, combining the measurements assigned to the group to obtain a corresponding concatenated array of measurements for that group; and
selecting a subset of the concatenated arrays by applying the optimisation procedure to optimise the objective function, the objective function providing a measure of differences between the values of each concatenated array and corresponding values of a reproduction of the concatenated array obtained using the reproduction function, the domain of the reproduction function comprising the concatenated arrays of the measurements in the subset and excluding the concatenated arrays of measurements not in the subset; and
combining measurements from the concatenated arrays in the subset to select the subset of the dataset for use in training the inference model.

7. A method according to any one of claims 2 to 6, wherein the metadata is indicative of from which of a plurality of regions of the product the measurement was obtained.

8. A method according to any one of claims 2 to 7, wherein the metadata is indicative of from which of a plurality of metrology targets formed on or within the product the measurement was obtained.

9. A method according to any one of claims 2 to 8, wherein the metadata is indicative of from which product the measurement was obtained.

10. A method according to any one of clauses 2 to 9, wherein the metadata is indicative of which of a plurality of acquisition channels of a measurement process was used to obtain the measurement.

11. A method of determining one or more parameters of a product of a fabrication process from measurements of the product, the method comprising:

obtaining a dataset of measurements of one or more products of the fabrication process, each of the measurements comprising an array of values obtained by measuring a corresponding one of the products, wherein each of the measurements in the dataset corresponds to a respective one of a plurality of measurements selected from another dataset of measurements of one or more products of the fabrication process, each of the measurements comprising an array of values obtained by measuring a corresponding one of the products of the fabrication process, the subset being selected by applying an optimisation procedure to an objective function providing a measure of differences between each measurement in the other dataset and corresponding reproduced values of the measurements obtained using a reproduction function having a domain comprising the measurements in the subset and excluding the measurements not in the subset; and

using an inference model trained using the measurements of the dataset and/or the measurements of the proper subset of the other dataset to determine the one or more parameters of each of the one or more products.

12. A method according to clause 11, wherein the inference model is trained using the measurements in the dataset in combination with known values of the one or more parameters of each of the one or more products of the fabrication process.

13. A computing system comprising a processor and a memory, the memory storing program instructions operative, upon being performed by the processor to cause the processor to perform a method according to any one of claims 1 to 12.

14. A metrology system for determining one or more parameters of a product of a fabrication process from metrology signals characterising the product, the metrology system comprising a computing system according to claim 13 and a metrology apparatus configured to perform measurements on the product to obtain the metrology signals.

15. A computer program product storing program instructions operative, upon being performed by the processor to cause the processor to perform a method according to any of claims 1 to 12.

**FIG. 1**

**FIG. 2**

FIG. 3

FIG. 4

500

502: Obtain a dataset of measurements of one or more products of the fabrication process, each of the measurements comprising an array of values obtained by measuring a corresponding one of the products.

504: Select a proper subset of the dataset for use in training the inference model, the subset being selected by applying an optimisation procedure to an objective function providing a measure of differences between each measurement in the dataset and corresponding reproduced values of the measurements obtained using a reproduction function having a domain comprising the measurements in the subset and excluding the measurements not in the subset.

506: Train the inference model using the proper subset of the dataset.

**FIG. 5**

600

**FIG. 6**

**FIG. 7**

**FIG. 8**

**FIG. 9**

FIG. 10A

FIG. 10B

FIG. 10C

FIG. 10D

FIG. 10E

FIG. 10F

**FIG. 11**

# EP 4 361 726 A1

Europäisches Patentamt
European Patent Office
Office européen des brevets

## EUROPEAN SEARCH REPORT

Application Number

EP 22 20 3256

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2020/182468 A1 (ASML NETHERLANDS BV [NL]) 17 September 2020 (2020-09-17) <br> * paragraphs [0006] - [0011] * <br> * paragraphs [0072] - [0073] * <br> * paragraphs [0086] - [0087]; figure 7 * <br> * paragraphs [0098] - [0117] * <br> * clauses 42-46 * <br> ----- | 1-15 | INV. <br> G03F7/20 <br> G06N3/08 <br> G06N20/00 |
| Y | KANG SEOKHO ET AL: "Efficient Feature Selection-Based on Random Forward Search for Virtual Metrology Modeling", <br> IEEE TRANSACTIONS ON SEMICONDUCTOR MANUFACTURING, IEEE SERVICE CENTER, PISCATAWAY, NJ, US, <br> vol. 29, no. 4, <br> 1 November 2016 (2016-11-01), pages 391-398, XP011626970, <br> ISSN: 0894-6507, DOI: 10.1109/TSM.2016.2594033 <br> [retrieved on 2016-10-27] <br> * IVC. Experimental Design; figure 1 * <br> * V. Conclusion * <br> ----- <br> -/-- | 1-15 | |

TECHNICAL FIELDS SEARCHED (IPC)

G03F
G06N

The present search report has been drawn up for all claims

| Place of search | Date of completion of the search | Examiner |
|---|---|---|
| Munich | 5 April 2023 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

28

Europäisches
Patentamt

European
Patent Office

Office européen
des brevets

# EUROPEAN SEARCH REPORT

Application Number

EP 22 20 3256

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CHEN CHING-HSIEN ET AL: "Virtual metrology of semiconductor PVD process based on combination of tree-based ensemble model", ISA TRANSACTIONS, INSTRUMENT SOCIETY OF AMERICA. PITTSBURGH, US, vol. 103, 31 March 2020 (2020-03-31), pages 192-202, XP086222073, ISSN: 0019-0578, DOI: 10.1016/J.ISATRA.2020.03.031 [retrieved on 2020-03-31] * abstract * * 3a. Data Preparation * * 3.2. Experimental Result; figure 7 * | 1-15 | |
| A | WO 2022/111967 A2 (ASML NETHERLANDS BV [NL]) 2 June 2022 (2022-06-02) * paragraphs [0059] - [0070]; figure 5 * | 1,11, 13-15 | |

TECHNICAL FIELDS
SEARCHED (IPC)

The present search report has been drawn up for all claims

| Place of search | Date of completion of the search | Examiner |
|---|---|---|
| Munich | 5 April 2023 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 3256

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2023

| Patent document cited in search report | | Publication date | Patent family member(s) | | Publication date |
|---|---|---|---|---|---|
| WO 2020182468 | A1 | 17-09-2020 | CN | 113574458 A | 29-10-2021 |
| | | | TW | 202040265 A | 01-11-2020 |
| | | | TW | 202141175 A | 01-11-2021 |
| | | | US | 2022171290 A1 | 02-06-2022 |
| | | | WO | 2020182468 A1 | 17-09-2020 |
| WO 2022111967 | A2 | 02-06-2022 | TW | 202227904 A | 16-07-2022 |
| | | | WO | 2022111967 A2 | 02-06-2022 |

EPO FORM P0459

For more details about this annex : see Official Journal of the European Patent Office, No. 12/82

**EP 4 361 726 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B

- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1

**Non-patent literature cited in the description**

- **M. JONEIDI et al.** Select to Better Learn: Fast and Accurate Deep Learning Using Data Selection From Nonlinear Manifolds. *IEEE/CVF Conference on Computer Vision and Pattern Recognition (CVPR),* 2020, 7816-7826